# FASCICULE DE BREVET EUROPEEN

(11) **EP 2 986 582 B1**
(45) Date de publication et mention de la délivrance du brevet: **29.03.2017**
(21) Numéro de dépôt: 14721469.6
(22) Date de dépôt: 10.04.2014
(51) Int. Cl.: C04B 35/56, C04B 35/565, C04B 35/573, C04B 35/628, C04B 35/65, C04B 35/80, C04B 35/83, C04B 35/563

(54) **PROCEDE DE FABRICATION DE MATERIAU COMPOSITE A MATRICE CARBURE**
VERFAHREN ZUR HERSTELLUNG EINES VERBUNDWERKSTOFFS MIT CARBIDMATRIX
PROCESS FOR MANUFACTURING A CARBIDE MATRIX COMPOSITE MATERIAL

(30) Priorité: 19.04.2013 FR 1353623
(43) Date de publication de la demande: 24.02.2016
(73) Titulaire: Safran Ceramics, 33185 Le Haillan (FR); Commissariat à l'Energie Atomique et aux Energies Alternatives, 75015 Paris (FR); Centre National de la Recherche Scientifique (C.N.R.S.), 75016 Paris (FR)
(72) Inventeur: JACQUES, Sylvain, F-33400 Talence (FR); LEDAIN, Olivier, F-33600 Pessac (FR); MAILLE, Laurence, F-33600 Pessac (FR); DELCAMP, Adrien, F-33700 Merignac (FR); PIQUERO, Thierry, F-37230 Fondettes (FR)
(74) Mandataire: Desormiere, Pierre-Louis
(86) Numéro de dépôt international: PCT/FR2014/050868
(87) Numéro de publication internationale: WO 2014/170585

(56) Documents cités:
- EP-A1- 2 154 119
- WO-A2-2010/034937
- GB-A- 2 475 233
- US-A- 4 921 725
- US-A1- 2004 207 133
- RAPAUD O ET AL: "PROCESSING OF (PYC/TIC)N MULTILAYERED COATINGS BY PULSED CVD AND RCVD", JOURNAL DE PHYSIQUE IV, EDITIONS DE PHYSIQUE. LES ULIS CEDEX, FR, vol. 11, no. 3, 26 août 2001 (2001-08-26), pages 3391-3398, XP009016813, ISSN: 1155-4339

## Description

### Arrière-plan de l'invention

La présente invention concerne un procédé de densification d'un substrat poreux par une matrice présentant une phase continue en carbure. L'invention s'applique notamment, mais non exclusivement à la réalisation de pièces en matériau composite à matrice céramique (CMC) formées d'un renfort en fibres réfractaires (carbone ou céramique) densifié par une matrice au moins partiellement céramique. Des exemples de CMC sont les composites C/SiC (renfort en fibres de carbone et matrice en carbure de silicium), les composites C/C-SiC (renfort en fibres de carbone et matrice comprenant une phase carbone, généralement au plus près des fibres, et une phase carbure de silicium) et les composites SiC/SiC (fibres de renfort et matrice en carbure de silicium).

Il existe de nombreuses techniques de densification de substrats poreux permettant de former au sein de ceux-ci une matrice au moins partiellement en carbure. Parmi ces techniques, on citera notamment :
a) L'infiltration chimique en phase gazeuse (CVI) qui consiste en l'infiltration d'un mélange gazeux contenant l'ensemble des éléments formant le matériau au sein d'une préforme poreuse en vue de sa densification. La CVI possède une cinétique de dépôt constante au cours du temps. C'est une méthode apportant de bonnes propriétés au matériau. Cependant, pour obtenir une matrice de carbure homogène en évitant le bouchage prématuré de la périphérie de la préforme, il est nécessaire de travailler à basse pression et relativement basse température (≤ 1100°C) pour ralentir les cinétiques de croissance. Ceci entraîne une durée de fabrication importante des pièces par cette technique et rend le procédé coûteux. Des usinages sont parfois nécessaires afin de ré-ouvrir la porosité en périphérie et permettre un accès des gaz à coeur.
b) La voie liquide qui consiste à imprégner une préforme poreuse par une composition liquide, éventuellement chargée, contenant un précurseur organique du matériau carbure de la matrice. Le précurseur organique se présente habituellement sous forme d'un polymère, tel qu'une résine, éventuellement dilué dans un solvant. La transformation du précurseur en phase réfractaire est réalisée par traitement thermique, après élimination du solvant éventuel et réticulation du polymère. Le traitement thermique consiste à pyrolyser le précurseur organique pour transformer la matrice organique en une matrice céramique selon le précurseur utilisé et les conditions de pyrolyse. Toutefois, le matériau présente en général une porosité résiduelle due au retrait de matière lors de la pyrolyse.
c) La voie métal liquide (RMI, MI, LSI ...) qui consiste en l'introduction d'un métal fondu (par exemple Si, à haute température (>1400°C)) au sein d'une préforme poreuse contenant généralement une poudre ou un matériau poreux (par exemple C avec ou sans SiC) réagissant avec le métal pour former le matériau de matrice final. La non-réaction d'une partie du métal avec les poudres présentes dans la préforme entraîne la présence de métal libre résiduel au sein de la matrice finale (par exemple du silicium libre) qui peut entraîner une oxydation au sein du matériau et par conséquent, une dégradation des propriétés des fibres. Un effet de dit de « choking-off » peut également empêcher le comblement de certaines porosités.
d) la voie barbotine ou céramique qui consiste à imprégner les préformes fibreuses par une barbotine (mélange de particules de céramique de dimension submicronique, d'ajouts de frittage et d'eau) puis à sécher et à fritter l'ensemble à 1600-1800°C sous pression comme décrit notamment dans le document EP 0 675 091. Ce procédé s'applique cependant seulement aux CMC unidirectionnels en raison notamment du retrait de la matrice pendant le frittage, les ajouts étant en outre néfastes aux propriétés finales du matériau.

Le document Vincent et al. (H. Vincent, J.L. Ponthenier, L. Porte, C. Vincent and J. Bouix "Influence des conditions experimentales du depot de SiC par RCVD sur l'infiltration de substrats de carbone poreux" Journal of the Less Common Metals, 157 (1990) 1-13) décrit le dépôt en phase gazeuse réactive (RCVD) pour infiltrer de SiC des substrats de graphite massifs poreux ou de la poudre non agglomérée ou compactée. Dans le cas de la poudre, le but n'était pas de la consolider mais de modifier la surface des particules pour la protéger de l'oxydation. Dans le document Bouix et al. (J. Bouix, J.C. Viala, H. Vincent, C. Vincent, J. L. Ponthenier, J. Dazord "Process for coating carbon fibers with a carbide" patent US4921725 (A) - 1990-05-01), la RCVD a également été utilisée pour revêtir des fibres de carbone d'une couche de carbure protectrice sans pour autant densifier la préforme.

De même, le document de Rapaud et Al. ("Processing of (PyC/ TiC)n multilayered coatings by pulsed CVD and RCVD", J. Phys. IV France 11 (2001), pp.(3)391-(3)398) décrit l'utilisation de la RCVD pour revêtir des fibres de couches d'interphase à base de carbure.

Le document Tang et al. (S.F. Tang, J.Y. Deng, S.J. Wang, W.C. Liu, K. Yang "Ablation behaviors of ultra-high temperature ceramic composites" Materials Science and Engineering A 465 (2007) 1-7), décrit la réalisation de matériaux composites à partir de compacts crus de poudres micrométriques de ZrB₂, SiC, HfC et TaC consolidées par CVI de pyrocarbone. Dans ce cas, la phase matricielle continue n'est pas en carbure mais en pyrocarbone, phase sensible à l'environnement. Ces mêmes auteurs ont également réalisé des composites à partir d'une poudre de ZrB₂ de 1,5 µm consolidée par SiC (S.F. Tang, J.Y. Deng, S.J. Wang, W.C. Liu "Fabrication and characterization of an ultra-high-temperature carbon fiber-reinforced ZrB2-SiC matrix composite" Journal of the American Ceramic Society 90 (2007) 3320-3322) à l'aide d'une variante de la CVI appelée HCVI (« Heaterless Chemical Vapor Infiltration »).

US 2004/207133 A1 décrit la formation d'un CMC comprenant des fibres de carbone dans une matrice carbure par dépôt de carbone dans et entre les paquets de fibres, suivi d'une infiltration réactive de métal fondu.

Aucune des techniques de densification actuellement disponibles n'offre une solution satisfaisante permettant d'obtenir une densification de substrats poreux à la fois rapide et homogène dans tout le substrat, et ce avec une matrice ayant une phase continue en carbure, c'est-à-dire sans métal libre.

### Objet et résumé de l'invention

La présente invention a notamment pour but de répondre aux inconvénients précités. Ce but est atteint grâce à un procédé de densification d'un substrat poreux par une matrice, ledit procédé comportant les étapes de :
- fractionnement de la porosité présente dans le substrat poreux de manière à former dans ledit substrat un réseau de microporosités, ledit fractionnement étant réalisé avec une composition de comblement comprenant au moins une phase carbonée ou une phase carbure accessible via le réseau de microporosité,
- infiltration chimique en voie gazeuse réactive du réseau de microporosités formé par le matériau de comblement, l'infiltration étant réalisée avec une composition gazeuse réactive dépourvue de carbone et comprenant au moins un élément apte à réagir avec le carbone de la composition de comblement pour former un carbure.

Ainsi, avec le procédé de l'invention, la densification peut être accélérée en remplissant et en fractionnant la porosité importante présentée initialement par le substrat dans une première étape tout en permettant au final une densification optimale et homogène dans toute la microporosité du matériau par l'infiltration d'une voie gazeuse réactive dans une seconde étape. En effet, la couche de carbure(s) formée par réaction entre la phase carbone ou carbure de la composition de comblement et la composition gazeuse réactive infiltrée dans le substrat croît localement suivant une cinétique de croissance parabolique, c'est-à-dire que plus elle s'épaissit, plus sa croissance ralentit. Par conséquent, au début de l'infiltration, la couche de carbure(s) sera plus épaisse sur les parties de la composition de comblement située en périphérie du substrat que sur les parties situées plus profondément dans le substrat. Néanmoins, comme la croissance de la couche de carbure(s) se ralentit d'abord au niveau de la composition de comblement située en périphérie du substrat, il ne se produit pas de bouchage prématuré du substrat en surface, ce qui permet à la composition gazeuse réactive d'atteindre le coeur du substrat dans la suite de l'infiltration. En outre, en dépit du gradient de concentration de la composition gazeuse réactive entre la périphérie et le coeur du substrat, la couche de carbure(s) formée au coeur du substrat est au final aussi épaisse que celle présente à la périphérie du substrat, ce qui ne peut être obtenu avec une infiltration CVI classique, c'est-à-dire non réactive, où l'appauvrissement de la phase gazeuse au fur et à mesure de sa pénétration dans la profondeur du substrat limiterait l'épaisseur de la couche de matrice déposée. Dans la présente invention, la couche de carbure(s) est formée par réaction entre la composition gazeuse infiltrée et le carbone de la composition de comblement, ce qui implique, en outre d'une diffusion en phase gazeuse, une diffusion en phase solide du carbone présent dans la composition de comblement qui compense le gradient de concentration. On obtient ainsi en fin d'infiltration une densification homogène du substrat dans toute son épaisseur.

Selon un premier aspect de l'invention, le procédé comprend en outre la réalisation d'une structure fibreuse correspondant au substrat poreux à densifier. Le procédé de l'invention permet dans ce cas de fabriquer un matériau composite de type renfort fibreux densifié par une matrice carbure(s). Dans le cas de la réalisation d'un matériau composite CMC, la structure fibreuse est réalisée à partir de fibres de carbone ou de carbure de silicium.

Selon un deuxième aspect du procédé de l'invention, le fractionnement de la porosité comprend l'introduction dans le substrat poreux d'une poudre constituée de particules micrométriques ou submicroniques en matériau carboné ou carburé, ou comprenant au moins une couche de surface en matériau carboné ou carburé.

Selon un troisième aspect du procédé de l'invention, le fractionnement de la porosité comprend l'imprégnation du substrat poreux avec un précurseur liquide de carbone ou de carbure, ou d'un matériau carboné ou carburé, et la transformation du précurseur par pyrolyse.

Selon un quatrième aspect du procédé de l'invention, le fractionnement de la porosité comprend la formation dans le substrat poreux d'un aérogel ou xérogel en un matériau précurseur de carbone ou de carbure, ou d'un matériau carboné ou carburé, et la transformation du précurseur par pyrolyse.

Selon un cinquième aspect du procédé de l'invention, la composition gazeuse réactive comprend au moins un des éléments réactifs choisis parmi : le titane, le zirconium, le hafnium, le tantale, le silicium et le bore. La composition gazeuse réactive peut notamment comprendre au moins un gaz halogéné choisi parmi au moins : TiCl₄, ZrCl₄, HfCl₄, SiH₄, TaI₄, TaCl₅, SiCl₄, BCl₃ et BF₃.

Selon un sixième aspect du procédé de l'invention, l'infiltration chimique en voie gazeuse réactive est réalisée sous pression pulsée.

Selon un septième aspect de l'invention, le procédé comprend, avant le fractionnement de la porosité, la formation d'une couche d'un carbure ou de carbone pyrolytique sur les fibres de la structure fibreuse. Il peut également comprendre en outre la formation d'une couche de nitrure dépourvue de carbone sur la couche de carbure ou de carbone pyrolytique formée sur les fibres de la structure fibreuse.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- les figures 1A à 1C sont des vues schématiques montrant l'évolution de la densification d'un substrat de poudre de grains de carbone réalisée par infiltration chimique en voie gazeuse réactive,
- la figure 2 présente des courbes montrant l'évolution du taux de conversion des particules de carbone durant la densification du substrat des figures 1A à 1C en fonction de leur position dans le substrat,
- la figure 3 est un ordinogramme montrant les étapes d'un procédé de densification conformément à un mode de réalisation de l'invention,
- les figures 4A et 4B sont des vues schématiques montrant la densification d'une structure fibreuse conformément aux étapes de la figure 3,
- les figures 5A à 5C sont des photographies montrant le résultat obtenu au voisinage de la périphérie d'une préforme fibreuse à différents stades de son infiltration chimique par voie gazeuse réactive,
- les figures 6A à 6C sont des photographies montrant le résultat obtenu à une profondeur intermédiaire dans une préforme fibreuse à différents stades de son infiltration chimique par voie gazeuse réactive,
- les figures 7A à 7C sont des photographies montrant le résultat obtenu au coeur d'une préforme fibreuse à différents stades de son infiltration chimique par voie gazeuse réactive,
- la figure 8 est une photographie montrant une préforme fibreuse imprégnée d'une composition de comblement avant son infiltration chimique en voie gazeuse réactive.

### Description détaillée de modes de réalisation

La présente invention propose une méthode de densification d'un substrat poreux par une matrice en carbure(s) obtenue à partir d'une infiltration chimique en voie gazeuse réactive (RCVI) réalisée avec une composition gazeuse réactive dépourvue de carbone et apte à réagir avec du carbone présent dans le substrat pour former un ou plusieurs carbures.

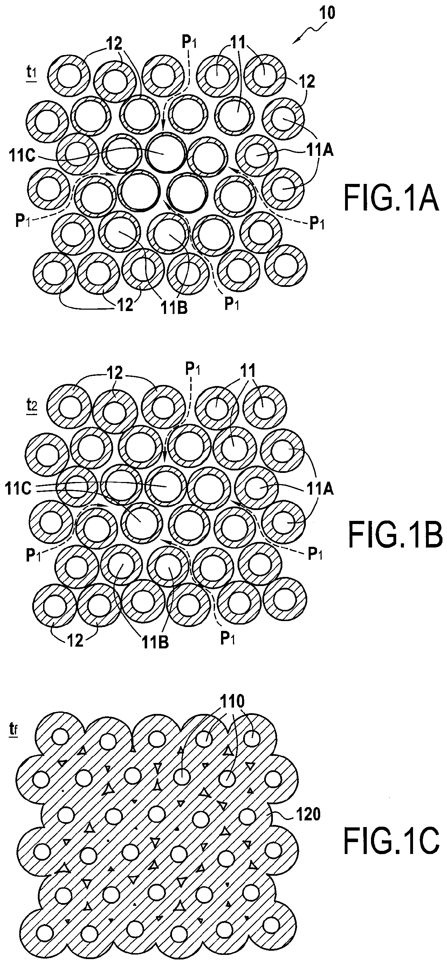

Les figures 1A à 1C illustrent l'évolution de la densification réalisée par RCVI dans un substrat poreux 10 constituée d'une poudre de grains de carbone 11 de taille submicronique, c'est-à-dire une taille inférieur au micromètre, ou micrométrique, c'est-à-dire une taille supérieure ou égale au micromètre. La poudre est infiltrée avec une phase gazeuse réactive P1 apte à former au moins un carbure par réaction entre le carbone des grains 11 et la phase gazeuse P1. Dans l'exemple décrit ici, la phase gazeuse réactive est constituée de TiCl₄ qui permet de former au contact des grains de carbone une matrice en carbure de titane (TiC). La couche de carbure croît localement autour de chaque particule ou grain carboné principalement par diffusion en phase solide du carbone et éventuellement d'autres éléments depuis la particule de substrat initiale vers la surface de la couche de carbure en cours de croissance. Ce mécanisme implique la consommation des particules carbonées lors de leur conversion en nouveau carbure.

Au début de l'infiltration représentée sur la figure 1A, la phase gazeuse P1 qui circule dans tout le substrat 10 réagit préférentiellement avec les grains de carbone 11A situés en périphérie du substrat 10, la couche de TiC 12 formée sur les grains 11 étant plus épaisse au niveau des grains 11A situés en périphérie du substrat 10 que sur les grains 11B situés entre le coeur du substrat et sa périphérie et surtout les grains 11C situés à coeur du substrat 10.

Dans la suite de l'infiltration représentée en figure 1B, la croissance de la couche de TiC ralentit au niveau des grains 11A tandis qu'elle s'amorce et se maintien sans ralentir au niveau des grains 11B puis 11C. Cette évolution de croissance entre la périphérie et le coeur du substrat au cours de la RCVI est due à une cinétique de croissance parabolique de la couche de carbure. En effet, la croissance locale de la couche de carbure ralentit proportionnellement avec l'augmentation de l'épaisseur de la couche formée car le mécanisme de diffusion en phase solide du carbone devient limitant.

Dans le cas d'une phase gazeuse réactive constituée de TiCl₄, la température de chauffage du substrat est choisie entre 800°C et 1200°C, ce qui permet de ne pas être limité par la réaction chimique tout en permettant que le phénomène de ralentissement de la croissance de la couche de carbure se produise à l'échelle de la taille de la porosité.

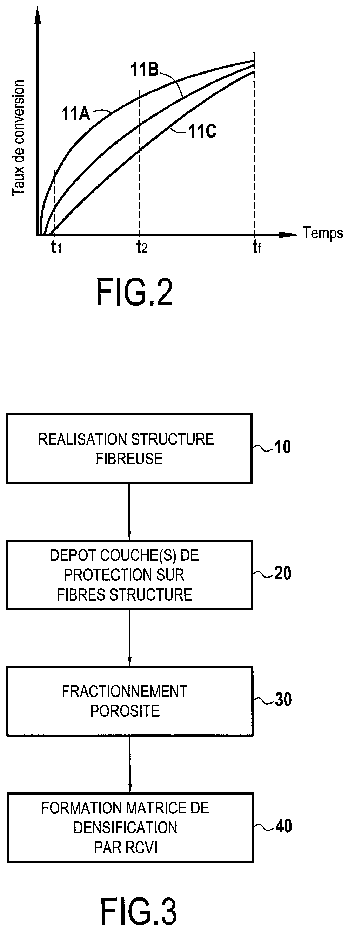

D'une manière générale, on choisit une température d'infiltration en fonction de la réactivité de la phase gazeuse afin d'obtenir un ralentissement de la croissance qui permet d'éviter le bouchage prématuré en périphérie du substrat poreux par une couche trop épaisse et de favoriser au contraire une croissance rapide de la couche qui serait restée mince au niveau de la porosité présente au coeur du substrat en raison du gradient de concentration des gaz réactifs. Cet auto-équilibre se crée donc grâce à deux mécanismes de transport différents. Le premier mécanisme de transport étant en phase gazeuse, à l'échelle de l'épaisseur du substrat (plusieurs millimètres) où le gradient en espèces réactives gazeuses entre le coeur et la périphérie est compensé par le second mécanisme de transport cette fois-ci en phase solide, à l'échelle locale de la taille de la porosité (submicronique ou micrométrique). Le taux de conversion des grains de carbone en fonction de leur position dans le substrat poreux et du temps d'infiltration est illustré sur la figure 2 qui montre bien que la croissance de la couche de carbure des grains 11A situés en périphérie du substrat est autocontrôlée par la diffusion solide du carbone tandis que la croissance de la couche des grains 11C situés à coeur du substrat est autocontrôlée par l'appauvrissement de la phase gazeuse réactive.

La cinétique de croissance parabolique ainsi que l'auto-équilibre obtenu par les mécanismes de transport différents en périphérie et à coeur permettent une densification homogène du substrat comme représentée sur la figure 1C où l'on constate, à la fin de la RCVI, que le substrat 10 est densifié de façon homogène par une matrice TiC 120 aussi bien en périphérie qu'à coeur, la matrice TiC 120 étant présente autour de particules fines 110 correspondant au reste des grains de carbone 11 non consommés.

Le procédé de l'invention s'applique particulièrement, mais non exclusivement, à la densification de substrats poreux tels que des mousses, des poudres et des préformes fibreuses destinées à être utilisées pour la fabrication de pièces en matériau composite notamment CMC.

Le procédé selon l'invention comprend, avant l'étape de RCVI, une étape de fractionnement de la porosité du substrat qui consiste à introduire dans le substrat une composition de comblement qui peut notamment comprendre :
- une poudre constituée de particules micrométriques ou submicroniques en matériau carboné ou carburé, ou comprenant au moins une couche de surface en matériau carboné,
- un précurseur liquide de carbone ou de carbure, ou d'un matériau carboné ou carburé, transformé ensuite par pyrolyse,
- un aérogel ou xérogel en un matériau précurseur de carbone ou de carbure, ou d'un matériau carboné ou carburé, transformés ensuite par pyrolyse.

L'étape de fractionnement permet de former dans le substrat un réseau de microporosités, c'est-à-dire une pluralité de pores communicants ayant chacun une taille comprise entre quelques nanomètres et quelques micromètres.

L'étape de RCVI vise à faire croître un nouveau carbure au sein du réseau de microporosités formé par le matériau de comblement constitué de carbone ou de carbure. A cet effet, comme en RCVD, on utilise un gaz réactif constitué de molécules comprenant au moins un élément apte à réagir avec le carbone en phase solide. Conformément à l'invention, la composition gazeuse réactive utilisée pour la RCVI ne contient pas l'élément carbone. L'objectif final de la RCVI est de densifier le réseau de microporosités.

Conformément à la RCVI mise en oeuvre dans la présente invention, les molécules de gaz de la composition gazeuse réagissent entre elles et/ou se décomposent pour libérer l'élément réactif à la surface de la phase carbonée ou phase carbure solide présente à l'intérieur du réseau de microporosités. Simultanément, l'élément libéré réagit avec le carbone de la phase solide initiale pour former le nouveau carbure. Ce phénomène peut se poursuivre grâce à la diffusion en phase solide du carbone à travers le nouveau carbure depuis la phase carbonée ou phase carbure initiale vers la surface (localement à l'intérieur des pores). La phase carbonée ou phase carbure initiale est progressivement consommée et transformée en nouveau carbure.

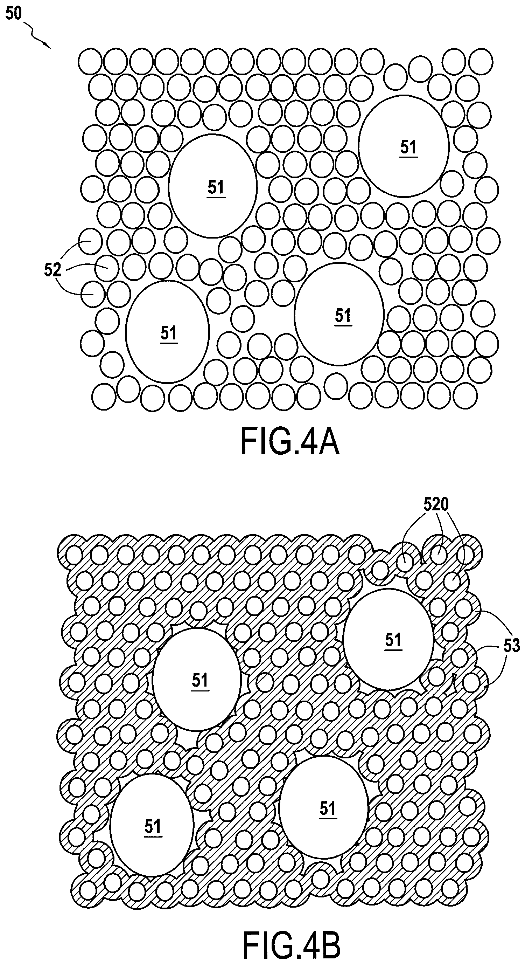

Un mode de réalisation du procédé de l'invention appliqué à la fabrication d'une pièce en matériau composite est décrit en relation avec les figures 3, 4A et 4B.

Le procédé de fabrication d'une pièce en matériau composite débute par la réalisation d'une structure fibreuse (étape 10).

La structure fibreuse peut être sous différentes formes, telles que :
- tissu bidimensionnel (2D),
- tissu tridimensionnel (3D) obtenu par tissage 3D ou multicouches,
- tresse,
- tricot,
- feutre,
- nappe unidirectionnelle (UD) de fils ou câbles ou nappes multidirectionnelle (nD) obtenue par superposition de plusieurs nappes UD dans des directions différentes et liaison des nappes UD entre elles par exemple par couture, par agent de liaison chimique ou par aiguilletage.

On peut aussi utiliser une structure fibreuse formée de plusieurs couches superposées de tissu, tresse, tricot, feutre, nappes ou autres, lesquelles couches sont liées entre elles par exemple par couture, par implantation de fils ou d'éléments rigides ou par aiguilletage.

Les fibres constitutives de la structure fibreuse sont des fibres réfractaires, c'est-à-dire des fibres en céramique, par exemple en carbure de silicium (SiC), des fibres en carbone ou même encore des fibres en un oxyde réfractaire, par exemple en alumine (Al₂O₃).

Les fibres peuvent être éventuellement revêtues d'une interphase formée par exemple d'une couche ou plusieurs couches de carbone pyrolytique (PyC), de carbone dopé au bore (BC) ou de nitrure de bore (BN).

Dans l'exemple décrit ici, la structure fibreuse est réalisée par tissage tridimensionnel ou multicouche en une seule pièce de fils de fibres de carbone tel que notamment décrit dans le document WO 2010/061140.

Conformément au procédé de l'invention, on fractionne tout d'abord la porosité présente dans le substrat poreux, ici la structure fibreuse, avec un matériau de comblement comprenant au moins une phase carbonée et/ou une phase carbure accessible via le réseau de microporosités de manière à former dans ledit substrat un réseau de microporosités (étape 30). Le matériau de comblement peut notamment être constitué de grains ou particules submicroniques ou micrométriques en matériau carboné ou carburé ou revêtus d'un tel matériau (grains à structure « core-shell ») présents sous la forme d'une suspension dans un liquide.

Dans le cas de substrats poreux contenant des constituants carbonés ou carburés comme c'est le cas notamment avec des structures fibreuses comprenant des fibres de carbone, des fibres de carbure de silicium, des fibres revêtues d'une interphase de carbone pyrolytique, etc., le substrat est préalablement traité afin de protéger ces constituants des réactions ultérieures lors de l'étape d'infiltration chimique en voie gazeuse réactive (étape 20). Cette protection peut être obtenue par pré-densification du substrat poreux par infiltration chimique en phase vapeur (CVI) avec un carbure ou du carbone pyrolytique qui joue alors le rôle de « couche sacrificielle » lors des réactions avec la ou les phases gazeuse de l'infiltration chimique en voie gazeuse réactive. Cette couche de protection peut être renforcée par le dépôt par CVI sur la couche sacrificielle d'une couche de nitrure ne contenant pas de carbone, comme par exemple du nitrure de titane (TiN) ou de zirconium (ZrN), qui joue le rôle de « barrière de diffusion » entre le carbone sous-jacent et la ou les phases gazeuse de l'infiltration chimique en voie gazeuse réactive. Dans l'exemple décrit ici, les fibres de carbone sont revêtues d'une couche de carbure de silicium et d'une couche de TiN toutes deux déposées par CVI.

Le fractionnement de la porosité est ici réalisé par transfert dans la structure fibreuse d'une barbotine aqueuse contenant une poudre de particules de carbone de taille submicronique ou micrométrique. Comme illustré sur la figure 4A, on obtient, après séchage, une structure fibreuse 50 dont la porosité présente entre les fibres 51 est comblée et fractionnée en un réseau de microporosités par des particules de carbone 52. La fraction volumique de la poudre introduite dans la préforme est comprise entre 25% et 75%. Elle est ajustée en fonction du taux final matériau carboné/carburé désiré en tenant compte de la consommation de carbone et, par conséquent, du taux de conversion des particules par la RCVI.

On procède ensuite à la RCVI en infiltrant la structure fibreuse 50 avec une composition gazeuse réactive dépourvue de carbone et comprenant un ou plusieurs éléments réactifs choisis parmi notamment le titane, le zirconium, le hafnium, le tantale, le silicium et le bore. La composition gazeuse réactive peut comprendre un ou plusieurs gaz halogénés choisi parmi notamment TiCl₄, ZrCl₄, HfCl₄, TaI₄, TaCl₅, SiCl₄, BCl₃ et BF₃, ou un gaz silane SiH₄.

Des exemples de réactions entre une phase carbonée ou phase carbure solide et une composition gazeuse réactive conforme à l'invention sont donnés ci-dessous :

TiCl₄(gaz) + 2H₂(gaz) + C(solide) -> TiC(solide) + 4HCl(gaz)

SiH₄(gaz) + C(solide) -> SiC(solide) + 2H₂(gaz)

TaI₄(gaz) + SiC(solide) -> TaC(solide) + SiI₄(gaz)

Les paramètres d'infiltration tels que la température et la pression sont ajustés en fonction de la composition de la phase gazeuse réactive. Comme expliqué ci-avant, la température est ajustée à une valeur suffisante pour permettre une réaction entre la composition gazeuse et le carbone présent sur les particules tout en permettant au phénomène de ralentissement de la croissance de la couche de carbure de se produire à l'échelle micrométrique ou submicronique correspondant à l'échelle des microporosités à combler. La composition gazeuse est infiltrée dans le substrat poreux à une pression comprise entre 1 mbar et 1 bar. La RCVI peut être en outre réalisée sous pression pulsée (P-RCVI) afin d'améliorer d'avantage l'homogénéité d'infiltration.

A la fin de la RCVI, on obtient comme représenté sur la figure 4B un matériau composite 50 comprenant un renfort fibreux constitué des fibres 51 et densifié par une matrice carbure(s)/carbone principalement constituée d'un ou plusieurs carbure(s) 53 entourant des particules fines 520 correspondant au reste des particules 52 non consommées.

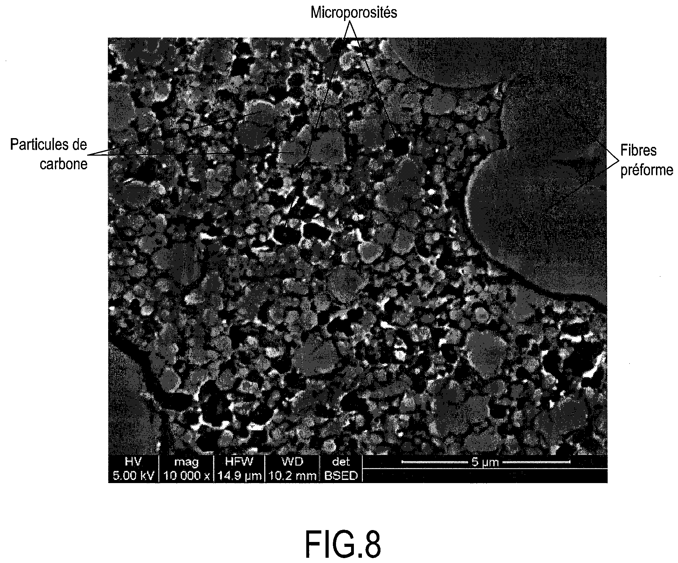

Des essais ont été réalisés sur des préformes en fibres de carbone ayant une épaisseur de l'ordre du millimètre, le fractionnement de la porosité de la préforme ayant été réalisé en imprégnant celle-ci par transfert avec une composition de comblement comprenant une poudre de particules de carbone de 600 nm de diamètre moyen appliquée en barbotine aqueuse, la préforme étant séchée à 70°C après imprégnation. La figure 8 est une photographie réalisée avec un microscope électronique à balayage en électrons rétrodiffusés montrant la préforme fibreuse imprégnée de la composition de comblement avant son infiltration chimique en voie gazeuse réactive. La préforme fibreuse a été ensuite soumise à une RCVI durant laquelle elle a été infiltrée avec une phase gazeuse constituée d'un mélange gazeux TiCl_{4/}H₂ de manière à former une matrice C/TiC dans la préforme.

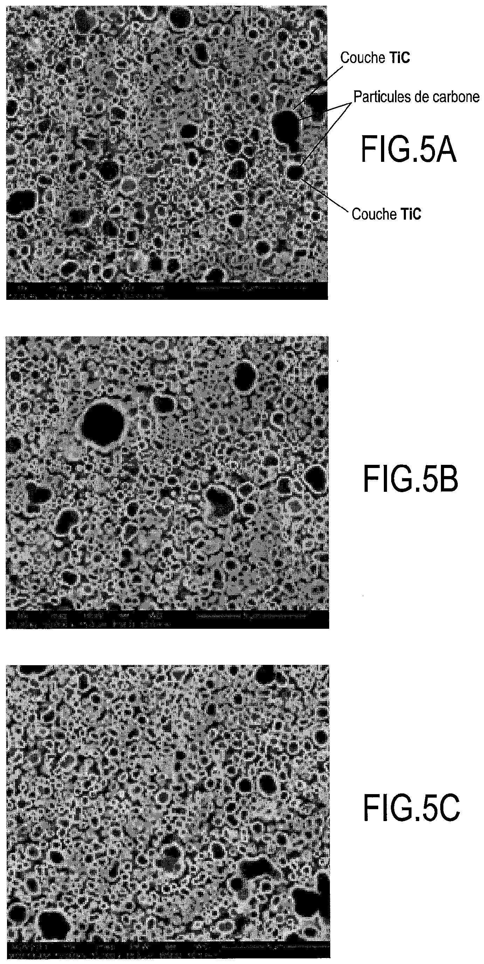

Les figures 5A à 5C sont des photographies réalisées avec un microscope électronique à balayage en électrons rétrodiffusés montrant le résultat au voisinage de la périphérie de la préforme (50 µm de profondeur) après respectivement 4 heures, 24 heures et 36 heures de d'infiltration d'un mélange gazeux TiCl_{4/}H₂ à 950°C. Les parties noires correspondent à du carbone tandis que les parties claires correspondent à du TiC.

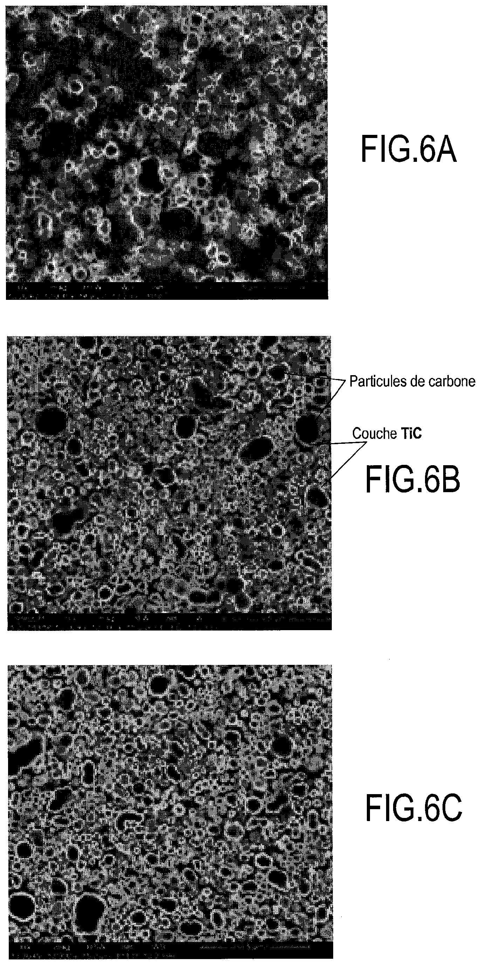

Les figures 6A à 6C sont des photographies réalisées avec un microscope électronique à balayage en électrons rétrodiffusés montrant le résultat à une profondeur intermédiaire dans la préforme (150 µm de profondeur) après respectivement 4 heures, 12 heures et 24 heures de d'infiltration d'un mélange gazeux TiCl₄/H₂ à 950°C. Les parties noires correspondent à du carbone tandis que les parties claires correspondent à du TiC.

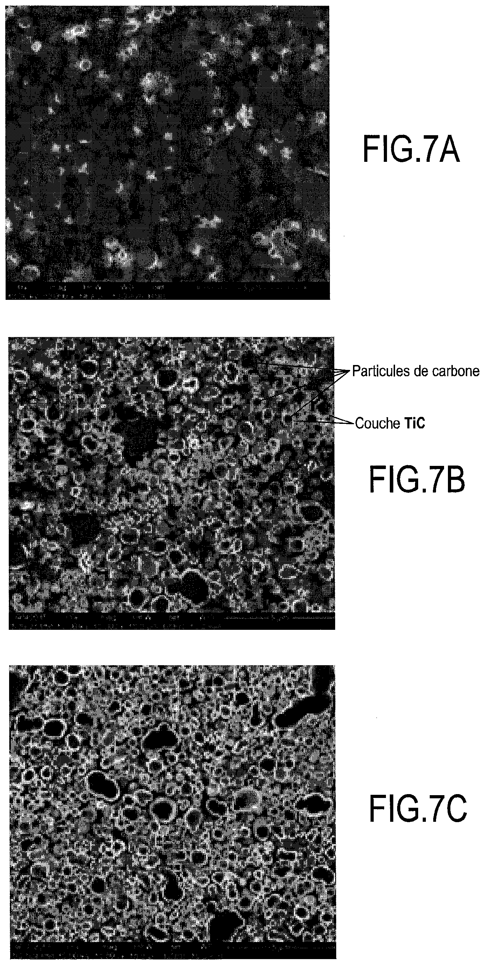

Les figures 7A à 7C sont des photographies réalisées avec un microscope électronique à balayage en électrons rétrodiffusés montrant le résultat au voisinage du coeur de la préforme (300 µm de profondeur) après respectivement 4 heures, 12 heures et 18 heures de d'infiltration d'un mélange gazeux TiCl₄/H₂ à 950°C. Les parties noires correspondent à du carbone tandis que les parties claires correspondent à du TiC.
Comme on peut le constater sur les photographies décrites ci-avant, même si la couche de carbure de TiC est d'une moindre épaisseur en début d'infiltration au niveau des particules de carbone présentes en-dessous de la périphérie de la préforme, cette couche est finalement présente avec une épaisseur homogène dans toute la préforme à la fin de l'infiltration.

## Revendications

1. Procédé de densification d'un substrat poreux (50) par une matrice, ledit procédé comportant les étapes de :
- fractionnement de la porosité présente dans le substrat poreux de manière à former dans ledit substrat un réseau de microporosités, ledit fractionnement étant réalisé avec une composition de comblement comprenant au moins une phase carbonée ou une phase carbure accessible via le réseau de microporosité,
- infiltration chimique en voie gazeuse réactive du réseau de microporosités formé par le matériau de comblement, l'infiltration étant réalisée avec une composition gazeuse réactive dépourvue de carbone et comprenant au moins un élément apte à réagir avec le carbone de la composition de comblement pour former un carbure (53).

2. Procédé selon la revendication 1, **caractérisé en ce qu'**il comprend en outre la réalisation d'une structure fibreuse correspondant au substrat poreux (50) à densifier.

3. Procédé selon la revendication 2, **caractérisé en ce que** la structure fibreuse est réalisée à partir de fibres de carbone (51) ou de carbure de silicium.

4. Procédé selon l'une quelconque des revendications 1 à 3, **caractérisé en ce que** le fractionnement de la porosité comprend l'introduction dans le substrat poreux d'une poudre constituée de particules micrométriques ou sub-micrométriques (52) en matériau carboné ou carburé, ou comprenant au moins une couche de surface en matériau carboné ou carburé.

5. Procédé selon l'une quelconque des revendications 1 à 3, **caractérisé en ce que** le fractionnement de la porosité comprend l'imprégnation du substrat poreux avec un précurseur liquide de carbone ou de carbure, ou d'un matériau carboné ou carburé et la transformation du précurseur par pyrolyse.

6. Procédé selon l'une quelconque des revendications 1 à 3, **caractérisé en ce que** le fractionnement de la porosité comprend la formation dans le substrat poreux d'un aérogel ou xérogel en un matériau précurseur de carbone ou de carbure, ou d'un matériau carboné ou carburé et la transformation du précurseur par pyrolyse.

7. Procédé selon l'une quelconque des revendications 1 à 6, **caractérisé en ce que** la composition gazeuse réactive comprend au moins un des éléments réactifs choisis parmi : le titane, le zirconium, le hafnium, le tantale, le silicium et le bore.

8. Procédé selon la revendication 7, **caractérisé en ce que** la composition gazeuse réactive comprend au moins un gaz halogéné choisi parmi au moins : TiCl₄, ZrCl₄, HfCl₄, TaI₄, TaCl₅, SiCl₄, BCl₃ et BF₃.

9. Procédé selon l'une quelconque des revendications 1 à 8, **caractérisé en ce que** l'infiltration chimique en voie gazeuse réactive est réalisée sous pression pulsée.

10. Procédé selon la revendication 2 ou 3, **caractérisé en ce qu'**il comprend, avant le fractionnement de la porosité, la formation d'une couche d'un carbure ou de carbone pyrolytique sur les fibres de la structure fibreuse.

11. Procédé selon la revendication 10, **caractérisé en ce qu'**il comprend en outre la formation d'une couche de nitrure dépourvue de carbone sur la couche de carbure ou de carbone pyrolytique formée sur les fibres de la structure fibreuse.

## Patentansprüche

1. Verfahren zur Verdichtung eines porösen Substrats (50) durch eine Matrix, wobei das Verfahren die Schritte umfasst:
- des Aufteilens der in dem porösen Substrat vorhandenen Porosität, um in dem Substrat ein Netz aus Mikroporositäten zu bilden, wobei das Aufteilen mit einer Füllzusammensetzung, die wenigstens eine Kohlenstoffphase oder eine Karbidphase, welche über das Mikroporositätennetz zugänglich ist, umfasst, durchgeführt wird,
- der chemischen Infiltration über die reaktive Gasphase des durch das Füllmaterial gebildeten Netzes aus Mikroporositäten, wobei die Infiltration mit einer reaktiven Gaszusammensetzung, welche kohlenstofffrei ist und wenigstens ein Element umfasst, das geeignet ist, mit dem Kohlenstoff der Füllzusammensetzung zu reagieren, um ein Karbid (53) zu bilden, durchgeführt wird.

2. Verfahren nach Anspruch 1, **dadurch gekennzeichnet, dass** es ferner die Herstellung einer Faserstruktur, die dem zu verdichtenden porösen Substrat (50) entspricht, umfasst.

3. Verfahren nach Anspruch 2, **dadurch gekennzeichnet, dass** die Faserstruktur aus Kohlenstoff- (51) oder Siliziumkarbidfasern hergestellt wird.

4. Verfahren nach einem der Ansprüche 1 bis 3, **dadurch gekennzeichnet, dass** das Aufteilen der Porosität das Einbringen eines Pulvers, das aus mikrometrischen oder submikrometrischen Partikeln (52) aus Kohlenstoff- oder Karbidmaterial besteht, oder wenigstens eine Oberflächenschicht aus Kohlenstoff- oder Karbidmaterial umfasst, in das poröse Substrat umfasst.

5. Verfahren nach einem der Ansprüche 1 bis 3, **dadurch gekennzeichnet, dass** das Aufteilen der Porosität das Imprägnieren des porösen Substrats mit einem flüssigen Vorläufer von Kohlenstoff oder Karbid, oder eines Kohlenstoff- oder Karbidmaterials, und die Umwandlung des Vorläufers durch Pyrolyse umfasst.

6. Verfahren nach einem der Ansprüche 1 bis 3, **dadurch gekennzeichnet, dass** das Aufteilen der Porosität die Bildung eines Aerogels oder Xerogels aus einem Vorläufermaterial von Kohlenstoff oder Karbid, oder eines Kohlenstoff- oder Karbidmaterials, in dem porösen Substrat und die Umwandlung des Vorläufers durch Pyrolyse umfasst.

7. Verfahren nach einem der Ansprüche 1 bis 6, **dadurch gekennzeichnet, dass** die reaktive Gaszusammensetzung wenigstens eines der reaktiven Elemente, die aus Titan, Zirkonium, Hafnium, Tantal, Silizium und Bor ausgewählt sind, umfasst.

8. Verfahren nach Anspruch 7, **dadurch gekennzeichnet, dass** die reaktive Gaszusammensetzung wenigsten ein Halogengas, das wenigstens aus TiCl₄, ZrCl₄, HfCl₄, TaI₄, TaCl₅, SiCl₄, BCl₃ und BF₃ ausgewählt ist, umfasst.

9. Verfahren nach einem der Ansprüche 1 bis 8, **dadurch gekennzeichnet, dass** die chemische Infiltration über die reaktive Gasphase unter gepulstem Druck durchgeführt wird.

10. Verfahren nach Anspruch 2 oder 3, **dadurch gekennzeichnet, dass** es vor dem Aufteilen der Porosität die Bildung einer Schicht aus einem Karbid oder aus pyrolytischem Kohlenstoff auf den Fasern der Faserstruktur umfasst.

11. Verfahren nach Anspruch 10, **dadurch gekennzeichnet, dass** es ferner die Bildung einer kohlenstofffreien Nitridschicht auf der auf den Fasern der Faserstruktur gebildeten Schicht aus Karbid oder aus pyrolytischem Kohlenstoff umfasst.

## Claims

1. A method of densifying a porous substrate (50) with a matrix, said method comprising the steps of:
• subdividing the pores present in the porous substrate so as to form in said substrate a network of micropores, said subdividing being performed with a filler composition comprising at least one carbon-containing phase or carbide-containing phase that is accessible via the network of micropores; and
• infiltrating the network of micropores formed by the filler material by reactive chemical vapor infiltration, the infiltration being performed with a reactive gas composition that does not contain carbon and that includes at least one element suitable for reacting with the carbon of the filler composition in order to form a carbide (53).

2. A method according to claim 1, **characterized in that** it further comprises making a fiber structure corresponding to the porous substrate (50) that is to be densified.

3. A method according to claim 2, **characterized in that** the fiber structure is made from carbon fibers (51) or from silicon carbide fibers.

4. A method according to any one of claims 1 to 3, **characterized in that** the subdividing of the pores comprises introducing a powder into the porous substrate, the powder being constituted by micrometer or submicrometer particles (52) of carbon-containing or carbide-containing material, or including at least a surface layer of carbon-containing or carbide-containing material.

5. A method according to any one of claims 1 to 3, **characterized in that** the subdividing of the pores comprises impregnating the porous substrate with a liquid precursor for carbon or carbide, or for a carbon-containing or carbide-containing material, and transforming the precursor by pyrolysis.

6. A method according to any one of claims 1 to 3, **characterized in that** the subdividing of the pores comprises forming in the porous substrate an aerogel or xerogel of a precursor material for carbon or carbide or for a carbon-containing or carbide-containing material, and transforming the precursor by pyrolysis.

7. A method according to any one of claims 1 to 6, **characterized in that** the reactive gas composition comprises at least one of the reactive elements selected from: titanium, zirconium, hafnium, tantalum, silicon, and boron.

8. A method according to claim 7, **characterized in that** the reactive gas composition comprises at least one halide gas selected from at least: TiCl₄, ZrCl₄, HfCl₄, TaI₄, TaCl₅, SiCl₄, BCl₃, and BF₃.

9. A method according to any one of claims 1 to 8, **characterized in that** the reactive chemical vapor infiltration is performed under pulsed pressure.

10. A method according to claim 2 or claim 3, **characterized in that** prior to subdividing the pores, the method comprises forming a layer of a carbide or of pyrolytic carbon on the fibers of the fiber structure.

11. A method according to claim 10, **characterized in that** it further comprises forming a layer of nitride having no carbon on the layer of carbide or of pyrolytic carbon formed on the fibers of the fiber structure.
